# EUROPEAN PATENT APPLICATION

(11) **EP 3 211 667 A1**
(43) Date of publication of application: **30.08.2017**
(21) Application number: 15852972.7
(22) Date of filing: 23.06.2015
(51) Int. Cl.: H01L 23/373, B32B 9/00, B32B 25/20, C08K 3/22, C08K 5/14, C08K 5/5415, C08L 83/05, C08L 83/07, H01L 23/36, H05K 7/20

(54) **HEAT DISSIPATION SHEET**

(30) Priority: 21.10.2014 JP 2014214416
(71) Applicant: Shin-Etsu Chemical Co., Ltd., Tokyo 100-0004 (JP)
(72) Inventor: AOKI, Yoshitaka, Annaka-shi Gunma 379-0224 (JP)
(74) Representative: Merkle, Gebhard
(86) International application number: PCT/JP2015/067962
(87) International publication number: WO 2016/063573

(57) **Abstract**

Provided is a heat dissipation sheet with which, after effectively conducting heat from a heat-emitting electronic component in the in-plane direction or the perpendicular direction, the heat is absorbed or diffused and infrared radiation is given off from the surface. A heat dissipation sheet provided with a graphite sheet layer and a heat-radiating silicone rubber sheet layer, the sheet obtained by layering, without providing an adhesive layer, a heat-radiating silicone rubber sheet and a graphite sheet in which pores are impregnated with a silicone resin, or curing of the graphite layer is performed following impregnation with a curable silicone composition.

## Description

### TECHNICAL FIELD

This invention relates to a heat-dissipating sheet having a high heat dissipating ability, adapted to diffuse heat from a heat-generating electronic part in an in-plane direction (i.e., a horizontal or parallel direction to a sheet surface) and a perpendicular direction and then emit the heat as infrared radiation from an outer surface.

### BACKGROUND ART

As LSI chips such as CPU, driver ICs and memories used in electronic equipment such as personal computers are advanced toward compact size and high integration, they release larger amounts of heat. The heat release brings to the chips a temperature rise which causes the chips to malfunction. To suppress the temperature rise, many heat dissipating members have been proposed.

However, the above-mentioned trend of electronic equipment toward compact size, low profile and high performance prevents heat sinks from being mounted in many situations. In the case of smart phones and digital video cameras handy to carry, and LED luminaires to be mounted to or suspended from the ceiling, for example, heat sinks cannot be used because of size and weight, or it is desired to eliminate heat sinks. Under the circumstances, several heat dissipating countermeasures utilizing heat emission are reported.

Patent Document 1 (JP-A 2006-298703) proposes a method of molding a ceramic material obtained by firing cordierite particle powder having a high emission rate of infrared radiation into a member and using the member as a substrate or instead of a heat sink, for thereby emitting heat from a heat-generating body as radiant heat. This method, however, has the problem that since the ceramic material has a high rigidity, it is difficult to mold, and the member cannot be attached to the heat-generating body when the body surface is curved rather than flat.

Also Patent Document 2 (JP-A 2004-200199) proposes a heat-emissive sheet comprising a thin metal plate, a heat-emissive film formed on one surface of the metal plate, and an adhesive layer attached to the other surface of the metal plate. This sheet, however, has a low heat-emissive effect because the sheet includes the adhesive layer having a low thermal conductivity. No problems arise when the surface of a heat-generating body is fully flat. When the surface of a heat-generating body is rough or a plurality of heat-generating bodies have different heights, the sheet does not closely follow the surface of the heat-generating body or bodies. If the adhesive layer has a low thermal conductivity, it interferes with heat conduction to a heat-emissive layer, resulting in a substantial lowering of the heat-emissive effect. Also it has been studied to improve heat conduction in a perpendicular direction by reducing the contact thermal resistance between the heat-generating body surface and the heat-emissive sheet, but it has not been reported to improve the heat conduction (heat diffusion) in in-plane direction of the heat-emissive sheet itself.

Notably, the above patent documents and the following patent documents are cited as the prior art technology pertinent to the present invention.

### PRIOR ART DOCUMENTS

### PATENT DOCUMENTS

Patent Document 1: JP-A 2006-298703
Patent Document 2: JP-A 2004-200199
Patent Document 3: JP-A 2004-043612
Patent Document 4: JP-A 2013-144747

### SUMMARY OF THE INVENTION

### PROBLEMS TO BE SOLVED BY THE INVENTION

An object of the invention, which has been made under the above circumstances, is to provide a heat-dissipating sheet adapted to effectively conduct heat from a heat-generating electronic part in an in-plane direction and a perpendicular direction, absorb and diffuse the heat, and emit infrared radiation from a surface.

### MEANS FOR SOLVING THE PROBLEMS

Making extensive investigations to attain the above object, the inventor has found that a heat-dissipating sheet comprising a graphite sheet layer and a heat-emissive silicone rubber sheet layer (i.e., a laminate sheet consisting of a graphite sheet layer and a heat-emissive silicone rubber sheet layer) is obtained by stacking a heat-emissive silicone rubber sheet and a graphite sheet, which has been formed by impregnating it in pores with a silicone resin or impregnating it in pores with a curable silicone composition and curing the silicone composition, without intervening any adhesive layer. The heat-dissipating sheet thus obtained has such heat dissipating characteristics that when an outer surface of the graphite sheet layer is contacted with a heat-generating body, heat from the heat-generating body is effectively conducted through the graphite sheet layer in an in-plane direction and a perpendicular direction, the heat is absorbed and diffused by the heat-emissive silicone rubber sheet layer, and the heat-emissive silicone rubber sheet layer emits infrared radiation from its outer surface.

Accordingly, the invention provides a heat-dissipating sheet as defined below.
[1] A heat-dissipating sheet comprising a graphite sheet layer and a heat-emissive silicone rubber sheet layer, which is obtained by stacking a heat-emissive silicone rubber sheet and a graphite sheet, which has been formed by impregnating it in pores with a silicone resin or impregnating it in pores with a curable silicone composition and curing the silicone composition, without intervening any adhesive layer.
[2] The heat-dissipating sheet of [1] wherein when an outer surface of the graphite sheet layer is contacted with a heat-generating body, heat is conducted from the heat-generating body to the graphite sheet layer, the heat is absorbed and diffused by the heat-emissive silicone rubber sheet layer, and the heat-emissive silicone rubber sheet layer emits infrared radiation from its outer surface.
[3] The heat-dissipating sheet of [1] or [2] wherein the heat-emissive silicone rubber sheet is a cured product of a curable silicone rubber composition containing oxide ceramic.
[4] The heat-dissipating sheet of [3] wherein the curable silicone rubber composition containing oxide ceramic is a curable silicone rubber composition comprising
   (a) 100 parts by weight of an organopolysiloxane containing at least two silicon-bonded alkenyl groups per molecule, represented by the average compositional formula (1):

      RₐSiO_{(4-a)/2} (1)

      wherein R is independently a substituted or unsubstituted monovalent hydrocarbon group of 1 to 12 carbon atoms, and a is a positive number of 1.8 to 2.2,
   (b) an organohydrogenpolysiloxane containing at least two silicon-bonded hydrogen atoms per molecule, in such an amount that a molar ratio of silicon-bonded hydrogen atoms in component (b) to alkenyl groups in component (a) may range from 0.5 to 5.0,
   (c) an amount of a platinum base compound to give 0.1 to 1,000 ppm of platinum group metal element based on the weight of component (a), and
   (j) 2 to 200 parts by weight of oxide ceramic.
[5] The heat-dissipating sheet of [3] wherein the curable silicone rubber composition containing oxide ceramic is a curable silicone rubber composition comprising
   (d) 100 parts by weight of an organopolysiloxane containing at least two alkenyl groups per molecule,
   (e) 0.1 to 2 parts by weight of an organic peroxide compound, and
   (j) 2 to 200 parts by weight of oxide ceramic.
[6] The heat-dissipating sheet of any one of [1] to [5] wherein the curable silicone composition with which the graphite sheet is impregnated in pores is a curable silicone composition comprising
   (f) 100 parts by weight of an organopolysiloxane containing at least two silicon-bonded alkenyl groups per molecule, represented by the average compositional formula (2):

      R¹_{b}SiO_{(4-b)/2} (2)

      wherein R¹ is independently a substituted or unsubstituted monovalent hydrocarbon group of 1 to 12 carbon atoms, and b is a positive number of 1.8 to 2.2,
   (g) an organohydrogenpolysiloxane containing at least two silicon-bonded hydrogen atoms per molecule, in such an amount that a molar ratio of silicon-bonded hydrogen atoms in component (g) to alkenyl groups in component (f) may range from 0.5 to 5.0,
   (h) an amount of a platinum base compound to give 0.1 to 1,000 ppm of platinum group metal element based on the weight of component (f), and
   (i) 0.01 to 50 parts by weight of an alkoxy-containing organosilicon compound.
[7] The heat-dissipating sheet of any one of [1] to [5] wherein the silicone resin with which the graphite sheet is impregnated in pores is a heat-softening silicone resin which is substantially solid at room temperature.
[8] The heat-dissipating sheet of [7] wherein the heat-softening silicone resin contains difunctional siloxane structural units (D units) and trifunctional silsesquioxane structural units (T units).
[9] The heat-dissipating sheet of [7] or [8] wherein the heat-softening silicone resin has a softening point of 40 to 120°C.
[10] The heat-dissipating sheet of any one of [1] to [9] wherein an area in in-plane direction of the heat-emissive silicone rubber sheet layer is greater than an area in in-plane direction of the graphite sheet layer opposed thereto.

### ADVANTAGEOUS EFFECTS OF THE INVENTION

The heat-dissipating sheet of the invention is a sheet having a high heat dissipating ability, adapted to diffuse heat from a heat-generating electronic part in an in-plane direction and a perpendicular direction and then emit infrared radiation from its surface.

### BRIEF DESCRIPTION OF THE DRAWINGS

[FIG. 1] FIG. 1 illustrates the construction of a heat-dissipating sheet of the invention obtained in Examples 1 to 6.
[FIG. 2] FIG. 2 is a plan view of a heat-dissipating sheet of the invention obtained in Example 7.
[FIG. 3] FIG. 3 is a transverse cross-sectional view of the heat-dissipating sheet in Example 7.
[FIG. 4] FIG. 4 schematically illustrates an instrument for measuring heat dissipation and heat emission in Examples of the invention.
[FIG. 5] FIG. 5 is an IR image of the heat-dissipating sheet obtained in Example 1.
[FIG. 6] FIG. 6 is an IR image of the heat-dissipating sheet obtained in Comparative Example 1.
[FIG. 7] FIG. 7 is an IR image of the heat-dissipating sheet obtained in Comparative Example 2.

### EMBODIMENT FOR CARRYING OUT THE INVENTION

The heat-dissipating sheet of the invention is described in detail.

### [Heat-dissipating sheet]

The invention provides a heat-dissipating sheet comprising a graphite sheet layer and a heat-emissive silicone rubber sheet layer, which is obtained by stacking a heat-emissive silicone rubber sheet and a graphite sheet, which has been formed by impregnating it in pores with a silicone resin or impregnating it in pores with a curable silicone composition and curing the silicone composition, without intervening any adhesive layer separately.

The heat-dissipating sheet functions such that when an outer surface of the graphite sheet layer is contacted with a heat-generating body, heat is conducted from the heat-generating body to the graphite sheet layer, the heat is absorbed and diffused by the heat-emissive silicone rubber sheet layer, and the heat-emissive silicone rubber sheet layer emits infrared radiation from its outer surface.

### [Heat-emissive silicone rubber sheet layer]

The heat-emissive silicone rubber sheet used as the heat-emissive silicone rubber sheet layer of the inventive heat-dissipating sheet is preferably a cured product of a curable silicone rubber composition containing oxide ceramic.

### [Curable silicone rubber composition]

The curable silicone rubber composition used to form the heat-emissive silicone rubber sheet layer of the heat-dissipating sheet is, for example, a curable silicone rubber composition of addition reaction cure type loaded with a predetermined amount of oxide ceramic, specifically comprising
(a) 100 parts by weight of an organopolysiloxane containing at least two silicon-bonded alkenyl groups per molecule, represented by the average compositional formula (1):

   RₐSiO_{(4-a)/2} (1)

   wherein R is independently a substituted or unsubstituted monovalent hydrocarbon group of 1 to 12 carbon atoms, and a is a positive number of 1.8 to 2.2,
(b) an organohydrogenpolysiloxane containing at least two silicon-bonded hydrogen atoms per molecule, in such an amount that a molar ratio of silicon-bonded hydrogen atoms in component (b) to alkenyl groups in component (a) may range from 0.5 to 5.0,
(c) an amount of a platinum base compound to give 0.1 to 1,000 ppm of platinum group metal element based on the weight of component (a), and
(j) 2 to 200 parts by weight of oxide ceramic.

Below the respective components of the curable silicone rubber composition are described.

### [(a) Alkenyl-containing organopolysiloxane]

Component (a) is an alkenyl-containing organopolysiloxane, which is an organopolysiloxane containing at least 2, preferably 2 to about 100, more preferably 2 to about 50 silicon-bonded alkenyl groups per molecule, represented by the average compositional formula (1):

RₐSiO_{(4-a)/2} (1)

wherein R is independently a substituted or unsubstituted monovalent hydrocarbon group of 1 to 12 carbon atoms, and a is a positive number of 1.8 to 2.2, preferably 1.95 to 2.05. It is a main component (or base polymer) in a curable silicone rubber composition of addition reaction cure type. Typically it is blocked at both ends of the molecular chain with triorganosiloxy groups (R₃SiO_{1/2} wherein R is as defined above, hereinafter) and its backbone is generally a straight chain structure consisting of repeating diorganosiloxane units (R₂SiO_{2/2}). It may have a branched structure in a part of the molecular structure or a cyclic structure although a linear diorganopolysiloxane is preferred from the standpoint of mechanical strength and other physical properties of a cured product.

In formula (1), R may be the same or different and stands for a substituted or unsubstituted monovalent hydrocarbon group of 1 to 12 carbon atoms, and preferably 1 to 10 carbon atoms. Suitable silicon-bonded functional groups other than alkenyl include alkyl groups such as methyl, ethyl, propyl, isopropyl, butyl, isobutyl, tert-butyl, pentyl, neopentyl, hexyl, heptyl, octyl, nonyl, decyl and dodecyl, cycloalkyl groups such as cyclopentyl, cyclohexyl and cycloheptyl, aryl groups such as phenyl, tolyl, xylyl, naphthyl and biphenylyl, aralkyl groups such as benzyl, phenylethyl, phenylpropyl and methylbenzyl, and substituted forms of the foregoing in which some or all carbon-bonded hydrogen atoms are substituted by halogen atoms such as fluorine, chlorine or bromine, cyano radicals or the like, e.g., chloromethyl, 2-bromoethyl, 3-chloropropyl, 3,3,3-trifluoropropyl, chlorophenyl, fluorophenyl, cyanoethyl, and 3,3,4,4,5,5,6,6,6-nonafluorohexyl. Of these, those of 1 to 10 carbon atoms are typical, those of 1 to 6 carbon atoms are more typical. Preferred are substituted or unsubstituted alkyl groups of 1 to 3 carbon atoms, such as methyl, ethyl, propyl, chloromethyl, bromoethyl, 3,3,3-trifluoropropyl and cyanoethyl and substituted or unsubstituted phenyl groups such as phenyl, chlorophenyl, and fluorophenyl. All silicon-bonded functional groups other than alkenyl may be the same or different.

Suitable alkenyl groups are those of about 2 to about 8 carbon atoms including vinyl, allyl, propenyl, isopropenyl, butenyl, hexenyl, and cyclohexenyl. Inter alia, lower alkenyl groups such as vinyl and allyl are preferred, with vinyl being most preferred. The alkenyl group may be bonded to a silicon atom at the end of the molecular chain, a silicon atom at a non-end (or intermediate) position of the molecular chain, or both. An organopolysiloxane containing at least alkenyl groups bonded to silicon atoms at both ends of the molecular chain is preferred.

The organopolysiloxane typically has a kinematic viscosity at 25°C in the range of 10 to 100,000 mm²/s, preferably 500 to 50,000 mm²/s. If the kinematic viscosity is too low, the resulting composition may have poor shelf stability. If the kinematic viscosity is too high, the resulting composition may be less extensible. It is noted that the kinematic viscosity as used herein may be measured by an Ostwald viscometer. Notably, the kinematic viscosity in the above range corresponds to a number average degree of polymerization of about 10 to about 1,100, especially about 50 to about 800, in the case of a linear organopolysiloxane.

The alkenyl-containing organopolysiloxane as component (a) may be used alone whereas a mixture of two or more having different kinematic viscosity may be used.

### [(b) Organohydrogenpolysiloxane]

Component (b) is an organohydrogenpolysiloxane having at least 2, preferably 2 to about 200, more preferably 3 to about 100 silicon-bonded hydrogen atoms (i.e., SiH groups) per molecule. It functions as a crosslinker or curing agent to component (a). Specifically, in the presence of a platinum base compound as component (c) to be described later, the silicon-bonded hydrogen atom in component (b) adds to the alkenyl group in component (b) through hydrosilylation reaction, forming a crosslinked cured product (cured silicone rubber) having a three-dimensional network structure with crosslinking bonds.

Suitable silicon-bonded organic groups in component (b) are, for example, substituted or unsubstituted monovalent hydrocarbon groups free of aliphatic unsaturation. Examples are the same as the silicon-bonded, substituted or unsubstituted, monovalent hydrocarbon groups (other than aliphatic unsaturated groups such as alkenyl groups) illustrated for component (a). Inter alia, methyl is preferred from the standpoints of easy synthesis and economy.

The structure of the organohydrogenpolysiloxane as component (b) is not particularly limited and may be any of linear, branched, cyclic and three-dimensional network structures, preferably linear.

The organohydrogenpolysiloxane typically has a degree of polymerization (or silicon count) of about 2 to 200, preferably about 2 to 100, more preferably about 2 to 50. It is noted that the degree of polymerization (or molecular weight) as used herein may be determined as a number average degree of polymerization (or number average molecular weight) as measured versus polystyrene standards by gel permeation chromatography (GPC) using toluene as developing solvent.

Preferred examples of the organohydrogenpolysiloxane as component (b) include
1,1,3,3-tetramethyldisiloxane,
1,3,5,7-tetramethylcyclotetrasiloxane,
tris(hydrogendimethylsiloxy)methylsilane,
tris(hydrogendimethylsiloxy)phenylsilane,
methylhydrogencyclopolysiloxane,
methylhydrogensiloxane/dimethylsiloxane cyclic copolymers,
molecular chain dual end trimethylsiloxy-blocked methylhydrogenpolysiloxane, molecular chain dual end trimethylsiloxy-blocked dimethylsiloxane/methylhydrogensiloxane copolymers,
molecular chain dual end trimethylsiloxy-blocked dimethylsiloxane/methylhydrogensiloxane/methylphenylsiloxane copolymers, molecular chain dual end dimethylhydrogensiloxy-blocked dimethylpolysiloxane, molecular chain dual end dimethylhydrogensiloxy-blocked dimethylsiloxane/methylhydrogensiloxane copolymers, molecular chain dual end dimethylhydrogensiloxy-blocked dimethylsiloxane/methylphenylsiloxane copolymers, molecular chain dual end dimethylhydrogensiloxy-blocked methylphenylpolysiloxane, copolymers consisting of (CH₃)₂HSiO_{1/2} units, (CH₃)₃SiO_{1/2} units, and SiO_{4/2} units, copolymers consisting of (CH₃)₂HSiO_{1/2} units and SiO_{4/2} units, and copolymers consisting of (CH₃)₂HSiO_{1/2} units, SiO_{4/2} units, and (C₆H₅)₃SiO_{1/2} units.

Notably, the organohydrogenpolysiloxane as component (b) may be used alone or in admixture of two or more.

Component (b) is preferably used in such an amount that 0.5 to 5.0 moles, more preferably 0.8 to 4.0 moles of SiH groups in component (b) are available per mole of alkenyl groups in component (a). If the amount of SiH groups in component (b) is less than 0.5 mole per mole of alkenyl groups in component (a), the composition may not cure or a cured product thereof may have a strength insufficient to handle as a molded body or composite body. If the amount of SiH groups exceeds 5.0 moles, it may be sometimes difficult to bind a rubber sheet layer with a graphite sheet layer.

### [(c) Platinum base compound]

Component (c) is a platinum base compound which is a catalyst component for promoting addition reaction between alkenyl groups in component (a) and silicon-bonded hydrogen in component (b) for converting the inventive composition into a crosslinked cured product (cured silicone rubber) of three-dimensional network structure.

Component (c) may be any appropriate one selected from well-known catalysts used in conventional hydrosilylation addition reaction. Exemplary are platinum group metals and platinum group metal compounds including platinum group metals alone such as platinum (inclusive of platinum black), rhodium and palladium, platinum chloride, chloroplatinic acid and chloroplatinic acid salts such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xH₂O, PtCl₂, Na₂HPtCl₄·xH₂O, wherein x is an integer of 0 to 6, preferably 0 or 6, alcohol-modified chloroplatinic acid, chloroplatinic acid-olefin complexes, platinum group metals such as platinum black and palladium on supports such as alumina, silica and carbon, rhodium-olefin complexes, chlorotris(triphenylphosphine)rhodium (Wilkinson catalyst), and complexes of platinum chloride, chloroplatinic acid and chloroplatinic acid salts with vinyl-containing siloxanes. These platinum base compounds may be used alone or in admixture of two or more.

An amount of the platinum base compound as component (c) is an effective and necessary amount to cure the composition and typically 0.1 to 1,000 ppm, preferably 0.5 to 500 ppm of platinum group metal element based on the weight of component (a).

### [(j) Oxide ceramic]

Suitable oxide ceramics as component (j) which contributes to heat emission of a curable silicone rubber composition used to form the heat-emissive silicone rubber sheet layer include metal oxide powders such as aluminum oxide powder, zinc oxide powder, magnesium oxide powder, iron oxide powder, titanium oxide powder, zirconium oxide powder, and silicon dioxide powder.

These powders may be used alone or in admixture of two or more.

The oxide ceramic preferably has a volume average particle size of 0.01 to 10 µm, more preferably 0.05 to 5 µm, as measured (typically as cumulative mass average diameter D₅₀ or median diameter) by Microtrac particle size analyzer MT3300EX (trade name by Nikkiso Group) based on the laser diffraction scattering method (microtrac method). A particle size of less than 0.01 µm may be difficult to handle. A particle size in excess of 10 µm may be difficult to exert a sufficient heat-emissive ability.

In the practice of the invention, it is acceptable to use two or more powders having different volume average particle sizes as the heat conductive filler.

An amount of the oxide ceramic as component (j) used is typically 2 to 200 parts, preferably 5 to 100 parts, and more preferably 10 to 70 parts by weight per 100 parts by weight of the alkenyl-containing organopolysiloxane as component (a). Notably, the content of oxide ceramic as component (j) is preferably about 2 to 50% by weight, more preferably about 5 to 20% by weight based on the total weight of the curable silicone rubber composition. If the amount of oxide ceramic used (or the content of oxide ceramic in the composition) is too small, the heat-emissive silicone rubber sheet layer may have a low heat-emissive ability. If the amount of oxide ceramic used (or the content in the composition) is too large, a uniform heat-emissive silicone rubber sheet layer may not be obtained.

Another example of the curable silicone rubber composition used to form the heat-emissive silicone rubber sheet layer of the heat-dissipating sheet is a curable silicone rubber composition of organic peroxide cure type comprising
(d) 100 parts by weight of an organopolysiloxane containing at least two alkenyl groups per molecule,
(e) 0.1 to 2 parts by weight of an organic peroxide compound, and
(j) 2 to 200 parts by weight of oxide ceramic.

The components of the curable silicone rubber composition are described below.

### [(d) Organopolysiloxane containing at least two alkenyl groups per molecule]

The organopolysiloxane containing at least two alkenyl groups per molecule as component (d) may be the same as defined and illustrated above for the alkenyl-containing organopolysiloxane as component (a).

### [(e) Organic peroxide compound]

Curing reaction of a silicone rubber composition with the aid of an organic peroxide takes place from radical polymerization of a linear organopolysiloxane having an alkenyl group (typically vinyl) at either one or both of an end (single end or dual ends) and non-end (intermediate) positions of the molecular chain in the presence of an organic peroxide compound. Examples of the organic peroxide compound as component (e) include diacyl peroxides and dialkyl peroxides. Since the organic peroxide compound is sensitive and unstable to light and heat, and since the organic peroxide compound in solid form is difficult to disperse in the composition, it is often used in diluted form with an organic solvent or dispersed form in the silicone component.

While the amount of the organic peroxide compound as component (e) may be a so-called catalytic amount, it is preferably about 0.1 to 2 parts by weight per 100 parts by weight of the alkenyl-containing organopolysiloxane as component (d).

### [(j) Oxide ceramic]

The oxide ceramic (j) may be the same as defined and illustrated above in conjunction with the curable silicone rubber composition of addition reaction cure type.

An amount of the oxide ceramic as component (j) used in the curable silicone rubber composition of organic peroxide cure type is typically about 2 to 200 parts, preferably about 5 to 100 parts, and more preferably about 10 to 70 parts by weight per 100 parts by weight of the alkenyl-containing organopolysiloxane as component (d). Notably, the content of oxide ceramic as component (j) is preferably about 2 to 50% by weight, more preferably about 5 to 20% by weight based on the total weight of the curable silicone rubber composition of organic peroxide cure type. If the amount of oxide ceramic used (or the content in the composition) is too small, the heat-emissive silicone rubber sheet layer may have a low heat-emissive ability. If the amount (or the content in the composition) is too large, a uniform heat-emissive silicone rubber sheet layer may not be obtained.

### [Preparation of curable silicone rubber composition]

The curable silicone rubber composition may be prepared by mixing the above components on a mixer such as a planetary mixer at room temperature (25°C±5°C) for about 0.5 to 5 hours, especially about 1 to 3 hours until uniform.

### [Graphite sheet layer]

Now the graphite sheet used to form the graphite sheet layer of the inventive heat-dissipating sheet is described. The graphite sheet has been formed by impregnating it in pores with a silicone resin or impregnating it in pores with a curable silicone composition and curing the silicone composition. Below, the starting graphite sheet, silicone resin and curable silicone composition used in the graphite sheet are described.

### [Graphite sheet]

Any graphite sheets may be used as long as they are porous. The graphite sheet preferably has a porosity (% by volume) of 30 to 80 vol%, more preferably 40 to 70 vol%. Notably, the porosity may be measured by the gas displacement method or in-liquid weighing method.

The graphite sheet may be, for example, a sheet obtained from pyrolysis of polymer film into graphite, and a commercially available one may be used. Commercial products include, for example, MacFoil (trade name by Japan Matex Co., Ltd.) and PGS Graphite Sheet (trade name by Panasonic Corp.).

The graphite sheet preferably has a thickness in the range of 3 to 500 µm, more preferably 5 to 200 µm. A sheet with a thickness of less than 3 µm may be short of strength, brittle and fragile. A sheet with a thickness in excess 500 µm may be difficult to manufacture and uneconomical.

### [Silicone resin to be impregnated into pores]

The silicone resin with which the graphite sheet layer of the inventive heat-dissipating sheet is impregnated in pores is, for example, a heat-softening silicone resin which is substantially solid (i.e., non-liquid having no self fluidity) at room temperature (25°C±5°C) or a heat-softening silicone resin compound comprising the same silicone resin and a heat conductive filler dispersed therein, which are described below.

As used herein, the "heat-softening" means that a resin is softened, lowered in viscosity or melted by heat (typically at 40°C or higher). A resin whose surface is fluidized as a result of thermal softening, viscosity lowering or melting is regarded as "heat-softening".

### [Heat-softening silicone resin]

The heat-softening silicone resin or the heat-softening silicone resin compound having a heat conductive filler dispersed therein may be any resin as long as it is substantially solid (i.e., non-liquid having no self fluidity) at room temperature (25°C±5°C) and is softened, lowered in viscosity or melted typically at a temperature in the range of from 40°C to the ultimate temperature reached by the heat generated by a heat-generating part, specifically about 40 to 120°C, more specifically about 40 to 90°C so that the resin surface in contact with the heat-generating part may fluidize.

In the practice of the invention, the heat-softening silicone resin should preferably have a softening point (or melting point) of 40 to 120°C, more preferably 45 to 100°C. If the softening point is lower than 40°C, a molded resin may develop noticeable fluidity and become difficult to handle when the ambient temperature is high. If the softening point exceeds 120°C, a resin having such a high heat-softening temperature may be difficult to mold. It is noted that the softening point may be determined by the falling ball measurement method (i.e., in a falling ball viscometer, the softening point is the temperature at which the falling ball submerges in the resin completely as the resin is heated to a higher temperature) or the like.

The heat-softening silicone resin or the heat-softening silicone resin compound having a heat conductive filler dispersed therein, to be applied to the graphite sheet layer of the invention, is not particularly limited as long as the above requirements are met. The important factor that governs the heat-softening behavior is the composition of silicone resin.

In particular, the heat conductive sheet resulting from a combination of the heat-softening silicone resin with the graphite sheet (i.e., the graphite sheet structure having pores impregnated and filled with the heat-softening silicone resin or heat-softening silicone resin compound having a heat conductive filler dispersed therein) must be substantially solid at room temperature. For this reason, examples of the heat-softening silicone resin include silicone resins which are copolymers of three-dimensional network structure containing trifunctional silsesquioxane structural units (referred to as T units) represented by branched structural units R'SiO_{3/2} and/or tetrafunctional structural units (referred to as Q units) represented by SiO₂ as a main component (e.g., at least 40 mol%, especially at least 50 mol%), preferably silicone resins which are copolymers of three-dimensional network structure containing T units and/or Q units and difunctional siloxane structural units (referred to as D units) represented by R'₂SiO, more preferably copolymers of three-dimensional network structure containing T units and/or Q units and D units, and end-capped with a monofunctional siloxy structural unit (referred to as M unit) represented by R'₃SiO_{1/2} (that is, a copolymer containing T units and/or Q units and further containing M units and D units).

Herein, preferably R' which may be the same or different is independently hydrogen or a C₁-C₈ monovalent hydrocarbon group (other than aryl) which may contain a carbonyl moiety. Examples of R' include hydrogen; alkyl groups such as methyl, ethyl, propyl, butyl, pentyl, and hexyl; cycloalkyl groups such as cyclopentyl and cyclohexyl; alkenyl groups such as vinyl, allyl, propenyl, isopropenyl and butenyl; and acyl groups such as acryloyl and methacryloyl. From the standpoint of availability of reactants, hydrogen, methyl, ethyl, and vinyl are more preferably used as R'.

The heat-softening silicone resin used herein may be one or more of the aforementioned silicone resin copolymers, typically of three-dimensional network structure, containing branched structural units. Further, a substantially linear (or partially branched linear, optionally containing a small amount of T units or Q units) organopolysiloxane containing D units as a main component (typically at least 80 mol%, preferably at least 90 mol%), having a backbone consisting essentially of repeating D units, and capped at molecular chain ends with M units (or not capped), for example, silicone oil or silicone gum may be added thereto, that is, a mixture of the three-dimensional network structure copolymer containing branched structural units and this organopolysiloxane may be used.

Among others, a silicone resin containing T units and D units (optionally M units), or a silicone resin composition which is a combination of a silicone resin containing T units with a silicone oil or silicone gum having a viscosity of at least 100 Pa·s at 25°C as measured by a rotational viscometer is preferred as the heat-softening silicone resin used herein. The silicone resin may be end-capped with R'₃SiO_{1/2} (M unit).

Further, the composition of the heat-softening silicone resin is described in more detail. The heat-softening silicone resin is typically of three-dimensional network structure containing T units and/or Q units as a main component and may be designed as consisting of M units and T units, or M units and Q units. However, in order to achieve high toughness in solid form (to make less brittle the graphite sheet layer which is formed by impregnating and filling the graphite sheet in pores with the heat-softening silicone resin or heat-softening silicone resin compound having a heat conductive filler dispersed therein, for thereby preventing rupture during handling), the introduction of T units is effective, more preferably in combination with D units. Herein, the substituent (R') in T units is desirably methyl or phenyl, and the substituent (R') in D units is desirably methyl, phenyl or vinyl. Additionally, the compositional ratio (molar ratio) of T units to D units is preferably from 10:90 to 90:10, especially from 20:80 to 80:20.

On use of the silicone resin consisting of M units and T units, or M units and Q units, as commonly used, as long as it is mixed with a high viscosity silicone oil containing T units, based on a structure of repeating D units, and terminated with M units (e.g., having a viscosity of at least 1,000 Pa·s at 25°C as measured by a rotational viscometer) or a gum-like silicone compound, the graphite sheet layer which is formed by impregnating and filling the graphite sheet in pores with the heat-softening silicone resin or heat-softening silicone resin compound having a heat conductive filler dispersed therein is improved in brittleness and prevented from pumping out (void generation and base siloxane runoff due to separation of base siloxane from graphite sheet) upon heat shock. Accordingly, when a silicone resin of three-dimensional network structure containing T units, but not D units is used, it is preferred to add a high viscosity silicone oil based on D units or a silicone gum compound to the silicone resin.

Therefore, when a silicone resin having a softening or melting point of higher than room temperature contains T units, but not D units, it may be converted to an easy-to-handle material by adding a high viscosity silicone oil based on D units or a silicone gum thereto, for the above-discussed reason. In this case, the amount of the high viscosity silicone oil based on D units or gum-like silicone compound added is preferably 1 to 100 parts, more preferably 2 to 10 parts by weight per 100 parts by weight of the silicone resin having a softening or melting point of higher than room temperature. If the amount is less than 1 part by weight, a pump-out phenomenon is likely to occur. If the amount exceeds 100 parts by weight, thermal resistance may be increased and heat conduction be retarded.

As alluded to above, a silicone resin having a relatively low molecular weight is desirably used in order to accomplish a critical (significantly temperature dependent) viscosity lowering. The heat-softening silicone resin should desirably have a molecular weight of 500 to 10,000, more desirably 1,000 to 6,000.

It is noted that the molecular weight is generally determined as a number average molecular weight versus polystyrene standards by gel permeation chromatography using toluene or the like as developing solvent.

It is noted that as the heat-softening silicone resin used herein, a resin capable of imparting strength and tack to the heat conductive sheet used herein is adequate. Although a polymer having a single viscosity may be used, a mixture of two or more polymers having different viscosities may also be used because a sheet having a good balance of strength and tack is obtained from the mixture.

Exemplary of the heat-softening silicone resin used herein is a silicone resin containing difunctional siloxane structural units (D units) and trifunctional silsesquioxane structural units (T units) in a specific proportion, as represented by the formula below.

D¹ₘTₚD²ₙ

Herein D¹ is a dimethylsiloxane unit (i.e., (CH₃)₂SiO), T is a phenylsilsesquioxane unit (i.e., (C₆H₅)SiO_{3/2}), D² is a methylvinylsiloxane unit (i.e., (CH₃)(CH₂=CH)SiO), a molar ratio (m+n)/p indicative of compositional ratio ranges from 0.25 to 4.0, and a molar ratio (m+n)/m ranges from 1.0 to 4.0.

Also exemplary is a silicone resin containing monofunctional siloxy structural units (M units), difunctional siloxane structural units (D units), and trifunctional silsesquioxane structural units (T units) in a specific proportion.

M₁D¹ₘTₚD²ₙ

Herein M is a trimethylsiloxane unit (i.e., (CH₃)₃SiO_{1/2}), D¹, T and D² are as defined above, a molar ratio (m+n)/p indicative of compositional ratio ranges from 0.25 to 4.0, a molar ratio (m+n)/m ranges from 1.0 to 4.0, and a molar ratio l/(m+n) ranges from 0.001 to 0.1.

Further exemplary is a silicone resin containing monofunctional siloxy structural units (M units), difunctional siloxane structural units (D units), and tetrafunctional structural units (Q units) in a specific proportion.

M₁D¹ₘQ_{q}D²ₙ

Herein Q is SiO_{4/2}, M, D¹ and D² are as defined above, a molar ratio (m+n)/q indicative of compositional ratio ranges from 0.25 to 4.0, a molar ratio (m+n)/m ranges from 1.0 to 4.0, and a molar ratio l/(m+n) ranges from 0.001 to 0.1.

These silicone resins may be used alone or in admixture of two or more.

### [Heat conductive filler]

Further, a heat conductive filler may be added to and dispersed in the heat-softening silicone resin in such an amount as not to prevent the resin surface in contact with a heat-generating electronic part from fluidizing. The resulting heat-softening silicone resin compound may be used herein.

As the heat conductive filler, any well-known materials commonly used as the heat conductive filler in the relevant application may be used without particular limitation. For example, metals such as copper, silver and aluminum; metal oxides such as alumina, silica, magnesium oxide, aluminum hydroxide, and zinc oxide; ceramics such as aluminum nitride, silicon nitride, silicon carbide and boron nitride; artificial diamond, etc. may be used. Inter alia, alumina and silica are preferred since they are readily available and relatively inexpensive.

The heat conductive filler preferably has an average particle size of 0.5 to 100 µm, more preferably 1 to 50 µm, most preferably 1 to 10 µm. A filler with too large an average particle size may have a small contact area with the silicone resin and be less resistant to pump-out. A filler with too small an average particle size may be difficult to mix with the silicone resin. It is noted that the average particle size may be determined as cumulative mass average diameter (or median diameter, D₅₀) on particle size distribution measurement by the laser light diffraction method.

The heat conductive filler is added in such an amount as not to prevent the resin surface in contact with a heat-generating electronic part from fluidizing. Specifically, the preferred amount of the heat conductive filler is 1 to 100 parts, especially 10 to 50 parts by weight per 100 parts by weight of the heat-softening silicone resin.

### [Preparation of heat-softening silicone resin compound]

The heat-softening silicone resin compound may be prepared by mixing the heat-softening silicone resin and heat conductive filler on a mixer such as a planetary mixer at a temperature of 80 to 160°C, especially 100 to 150°C for 0.5 to 5 hours, especially 1 to 3 hours.

### [Curable silicone composition to be impregnated into pores and cured]

In the inventive heat-dissipating sheet, the curable silicone composition with which the graphite sheet is impregnated in pores and which is cured therein whereby the pores of the graphite sheet are filled therewith is, for example, a curable silicone composition of addition reaction cure type comprising
(f) 100 parts by weight of an organopolysiloxane containing at least two silicon-bonded alkenyl groups per molecule, represented by the average compositional formula (2):

   R¹_{b}SiO_{(4-b)/2} (2)

   wherein R¹ is independently a substituted or unsubstituted monovalent hydrocarbon group of 1 to 12 carbon atoms, and b is a positive number of 1.8 to 2.2,
(g) an organohydrogenpolysiloxane containing at least two silicon-bonded hydrogen atoms per molecule, in such an amount that a molar ratio of silicon-bonded hydrogen atoms in component (g) to alkenyl groups in component (f) may range from 0.5 to 5.0,
(h) an amount of a platinum base compound to give 0.1 to 1,000 ppm of platinum group metal element based on the weight of component (f), and
(i) 0.01 to 50 parts by weight of an alkoxy-containing organosilicon compound.

Below the respective components of the curable silicone rubber composition are described.

### [(f) Alkenyl-containing organopolysiloxane]

Component (f) is an organopolysiloxane containing at least 2, preferably 2 to about 100, more preferably 2 to about 50 silicon-bonded alkenyl groups per molecule, represented by the average compositional formula (2):

R¹_{b}SiO_{(4-b)/2} (2)

wherein R¹ is independently a substituted or unsubstituted monovalent hydrocarbon group of 1 to 12 carbon atoms, and b is a positive number of 1.8 to 2.2, preferably 1.95 to 2.05. It is a main component (or base polymer) in the curable silicone composition. In formula (2), R¹ is as exemplified for R in formula (1).

The alkenyl-containing organopolysiloxane may be the same as defined and illustrated above for the alkenyl-containing organopolysiloxane as component (a).

### [(g) Organohydrogenpolysiloxane]

The organohydrogenpolysiloxane as component (g) may be the same as defined and illustrated above for the organohydrogenpolysiloxane as component (b).

The amount of component (g) added is preferably such that a molar ratio of SiH groups in component (g) to alkenyl groups in component (f) may range from 0.5 to 5.0, more preferably from 0.8 to 2.0. If the amount of component (g) is too small, a curable silicone composition may not cure. If the amount is too large, hydrogen may be given off with the lapse of time.

### [(h) Platinum base compound]

The platinum base compound as component (h) may be the same as defined and illustrated above for the platinum base compound as component (c).

An amount of component (h) is preferably 0.1 to 1,000 ppm, more preferably 1 to 200 ppm of platinum group metal element based on the weight of component (f).

### [(i) Alkoxy-containing organosilicon compound]

Component (i) is an alkoxy-containing organosilicon compound which functions as a surface treating agent for the purposes of improving the wettability of the graphite sheet with the curable silicone composition comprising components (f), (g) and (h) and the adhesion of the graphite sheet to the heat-emissive silicone rubber sheet layer.

Preferred as component (i) are an organoxysilane compound and a linear diorganopolysiloxane capped at one end of the molecular chain with a triorganoxysilyl group, especially components (i-1) and (i-2) shown below.

### (i-1) Alkoxysilane compound having the general formula (3):

R²_{c}R³_{d}Si(OR⁴)_{4-c-d} (3)

wherein R² is independently a C₆-C₁₅ alkyl group, R³ is independently a substituted or unsubstituted C₁-C₈ monovalent hydrocarbon group, R⁴ is independently a C₁-C₆ alkyl group, c is an integer of 1 to 3, d is 0, 1 or 2, c+d is an integer of 1 to 3.

In formula (3), examples of the alkyl group represented by R² include hexyl, octyl, nonyl, decyl, dodecyl, and tetradecyl. As long as the alkyl group represented by R² has 6 to 15 carbon atoms, especially 8 to 12 carbon atoms, the wettability of the graphite sheet is fully improved, handling operation is efficient, and low-temperature properties of the composition are good.

Examples of the substituted or unsubstituted monovalent hydrocarbon group represented by R³ include alkyl groups such as methyl, ethyl, propyl, hexyl and octyl; cycloalkyl groups such as cyclopentyl and cyclohexyl; alkenyl groups such as vinyl and allyl; aryl groups such as phenyl and tolyl; aralkyl groups such as 2-phenylethyl and 2-methyl-2-phenylethyl; and halogenated hydrocarbon groups such as 3,3,3-trifluoropropyl, 2-(nonafluorobutyl)ethyl, 2-(heptadecafluorooctyl)ethyl, and p-chlorophenyl. Inter alia, methyl and ethyl are most preferred.

Examples of the alkyl group represented by R⁴ include methyl, ethyl, propyl, butyl, pentyl, and hexyl. Inter alia, methyl and ethyl are most preferred.

Preferred examples of component (i-1) include the following.

C₆H₁₃Si(OCH₃)₃

C₁₀H₂₁Si(OCH₃)₃

C₁₂H₂₅Si(OCH₃)₃

C₁₂H₂₅Si(OC₂H₅)₃

C₁₀H₂₁Si(CH₃)(OCH₃)₂

C₁₀H₂₁Si(C₆H₅)(OCH₃)₂

C₁₀H₂₁Si(CH₃)(OC₂H₅)₂

C₁₀H₂₁Si(CH=CH₂)(OCH₃)₂

C₁₀H₂₁Si(CH₂CH₂CF₃)(OCH₃)₂

As component (i-1), the foregoing compounds may be used alone or in admixture of two or more.

### (i-2) Linear dimethylpolysiloxane capped at one end of the molecular chain with a trialkoxysilyl group, having the general formula (4):

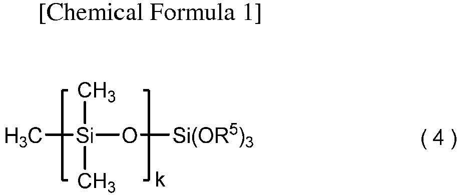

wherein R⁵ is independently a C₁-C₆ alkyl group, examples of which are the same as exemplified above for the alkyl group R⁴ in formula (3), and k is an integer of 5 to 100, preferably 10 to 50.

Preferred examples of component (i-2) include the following.

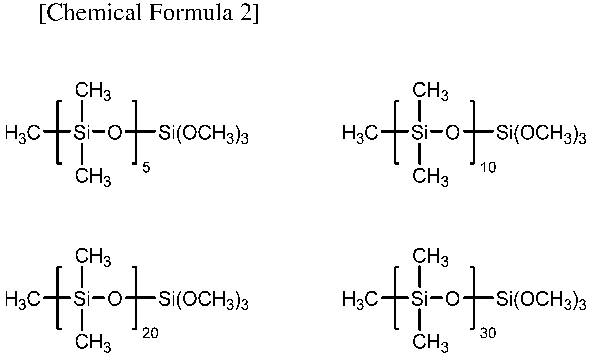

As component (i-2), the foregoing compounds may be used alone or in admixture of two or more.

In the invention, at least one compound selected from the group consisting of components (i-1) and (i-2) may be used. In this case, the amount of component (i) added to the curable silicone composition containing components (f), (g) and (h) is preferably 0.01 to 50 parts, more preferably 0.1 to 30 parts by weight per 100 parts by weight of component (f).

If the amount of component (i-1) added exceeds the range, it is uneconomical because the wetter effect is enhanced no longer. Since component (i-1) is volatile so that the composition or a cured product thereof may gradually become harder if it is allowed to stand in an open system, preferably the amount of component (i) is restricted to the necessary minimum. If the amount of component (i-2) added exceeds the range, a cured product of the composition tends to lose heat resistance and humidity resistance.

### [Preparation of curable silicone composition]

The curable silicone composition may be prepared by mixing the above components on a mixer such as a planetary mixer at room temperature (25°C±5°C) for 0.5 to 5 hours, especially 1 to 3 hours until uniform.

### [Solvent]

While a solvent may be used to improve the efficiency of operation in preparing the graphite sheet layer, examples of the solvent include toluene, xylene, hexane and heptane, with toluene and xylene being preferred. An amount of the solvent used is preferably 1 to 50 parts, more preferably 3 to 20 parts by weight per 100 parts by weight of the heat-softening silicone resin or component (f) in the curable silicone composition. A larger amount of the solvent may require a longer time for solvent removal whereas a smaller amount of the solvent may fail to improve operation efficiency.

### [Preparation of graphite sheet impregnated in pores with silicone resin]

Next, a method for preparing a graphite sheet filled in pores with a silicone resin is described.

Although one typical method for preparing a graphite sheet filled in pores with a silicone resin is described below, the method is not limited thereto as long as a graphite sheet is impregnated with a solvent dilution of the heat-softening silicone resin or the heat-softening silicone resin compound having a heat conductive filler dispersed therein and then dried.

The typical method includes the steps of:
(1) diluting the heat-softening silicone resin or the heat-softening silicone resin compound having a heat conductive filler dispersed therein with a solvent to form an impregnant liquid,
(2) immersing a graphite sheet in the impregnant liquid, and
(3) volatilizing off the solvent.

Another method using a coating equipment includes the steps of feeding a graphite sheet on a polymer film pretreated with a parting agent, coating an impregnant liquid onto the graphite sheet, the impregnant liquid being obtained by diluting the heat-softening silicone resin or the heat-softening silicone resin compound having a heat conductive filler dispersed therein with a solvent, passing the sheet through a heating furnace for volatilizing off the solvent, yielding the graphite sheet having pores filled with the silicone resin. In the coating step, pressure may be applied so that the heat-softening silicone resin or the heat-softening silicone resin compound having a heat conductive filler dispersed therein may be effectively impregnated into internal voids of the graphite sheet.

In this embodiment, the amount of the heat-softening silicone resin or the heat-softening silicone resin compound having a heat conductive filler dispersed therein impregnated or coated is preferably about 50 to 200 vol%, more preferably about 95 to 120 vol% calculated as the heat-softening silicone resin compound, based on the pore volume (i.e., a product of volume and porosity of graphite sheet) of the graphite sheet. If the impregnated or coated amount is too less, tight adhesion may be lost. If the amount is too much, a pump-out phenomenon may occur.

Treating conditions are not particularly limited as long as the solvent used is fully volatilized off. While heating conditions of the heating furnace depend on the type of solvent, a temperature of 50 to 200°C, especially 60 to 180°C is preferred in order to avoid bubble formation.

### [Preparation of graphite sheet by impregnating and curing curable silicone resin composition into pores]

Next, a method for preparing a graphite sheet having pores filled with (cured) silicone rubber, by impregnating a graphite sheet in pores with a curable silicone resin composition and curing the resin composition is described.

Although one typical method for preparing a graphite sheet having pores filled with (cured) silicone rubber by impregnating a graphite sheet in pores with a curable silicone resin composition and curing the resin composition is described below, the method is not limited thereto as long as a graphite sheet is impregnated with a solvent dilution of the curable silicone composition and then the silicone composition is cured.

Specifically, a graphite sheet having pores filled with a cured product (silicone rubber) of a curable silicone composition is prepared by feeding or placing an untreated porous graphite sheet on a polymer film (support) pretreated with a parting agent, coating a predetermined amount of a curable silicone composition onto the surface of the graphite sheet, placing another polymer film (support) pretreated with a parting agent on top of the graphite sheet for thereby sandwiching the graphite sheet between two parting agent-treated polymer films (supports), and operating a heat press machine for causing the graphite sheet to be impregnated in pores with the coated curable silicone resin and curing the curable silicone resin filled in pores.

In this embodiment, the amount of the curable silicone composition impregnated or coated is preferably about 50 to 200 vol%, more preferably about 95 to 120 vol% calculated as the curable silicone composition, based on the pore volume (i.e., a product of volume and porosity of graphite sheet) of the graphite sheet. If the impregnated or coated amount is too less, tight adhesion may be lost. If the amount is too much, a pump-out phenomenon may occur.

Curing conditions may be standard curing conditions for general addition cure type silicone compositions to cure and are not particularly limited. Although heating conditions depend on the molar ratio of SiH groups (g) to alkenyl groups (f) in the composition and the type of curing catalyst, preferred conditions include a temperature of 80 to 150°C, more preferably 100 to 130°C and a time of about 1 minute to 1 hour, more preferably about 5 to 30 minutes. The press machine preferably applies a pressure of about 0.1 to 35 MPa, more preferably about 0.5 to 5 MPa in order to avoid bubble formation.

### [Preparation of heat-dissipating sheet]

The heat-dissipating sheet of the invention is obtained by stacking a heat-emissive silicone rubber sheet layer on a graphite sheet layer which has been formed by impregnating it in pores with a silicone resin or impregnating it in pores with a curable silicone composition and curing the silicone composition. The technique of stacking a heat-emissive silicone rubber sheet layer on a graphite sheet layer may include, for example, a lamination technique, coating technique (coating a graphite sheet layer with a curable silicone rubber composition in uncured state and then curing the composition into a heat-emissive silicone rubber sheet), pressing technique or the like, although the technique is not limited thereto.

In the inventive heat-dissipating sheet, the graphite sheet layer desirably has a thickness of about 50 to 500 µm, more desirably about 100 to 250 µm. A graphite sheet layer of less than 50 µm is difficult to prepare whereas a layer of more than 500 µm is weak to bending and may crack when it is rounded into roll form. The heat-emissive silicone rubber sheet layer desirably has a thickness of about 10 to 1,000 µm, more desirably about 20 to 250 µm although the thickness is not particularly limited. A heat-emissive silicone rubber sheet layer of less than 10 µm may sometimes fail to exert the desired heat-emissive function whereas a layer of more than 1,000 µm corresponds to a higher percent volume, posing a limit to the application.

In a more preferred embodiment of the heat-dissipating sheet, an area in in-plane direction (i.e., area in a direction facing the stacked graphite sheet layer) of the heat-emissive silicone rubber sheet layer is greater than an area in in-plane direction (i.e., area in a direction facing the stacked heat-emissive silicone rubber sheet layer) of the graphite sheet layer. This prevents machining chips or debris of graphite from contacting the electronic part.

### EXAMPLES

Examples and Comparative Examples are given below for further illustrating the invention although the invention is not limited thereto. Notably, the viscosity is a measurement at 25°C.

### [Examples 1 to 7 and Comparative Examples 1 to 3]

First, a curable silicone rubber composition used to form a heat-emissive silicone rubber sheet layer to construct the inventive heat-dissipating sheet is formulated from the following components.

### <Heat-emissive silicone rubber composition>

### Component (a):

organopolysiloxanes of the following formula

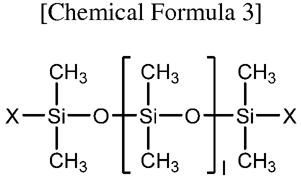

In the formula, X is vinyl, and 1 is a number providing the following viscosity.
(A-1) kinematic viscosity 600 mm²/s
(A-2) kinematic viscosity 30,000 mm²/s

### Component (b):

organohydrogenpolysiloxane (B-1) of the following formula

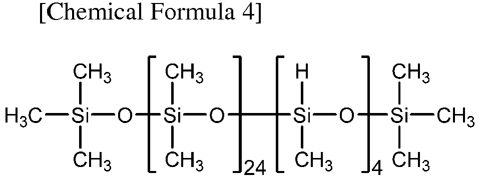

### Component (c):

5 wt% chloroplatinic acid toluene solution (C-1)

### Component (j) (oxide ceramic):

aluminum oxide, zinc oxide and silicon dioxide having the following average particle size
- (Al₂O₃-1): aluminum oxide powder with average particle size 5 µm
- (ZnO-2): zinc oxide powder with average particle size 1 µm
- (SiO₂-3): silicon dioxide powder with average particle size 5 µm

### Component (d):

organopolysiloxane (D-1) of the following formula

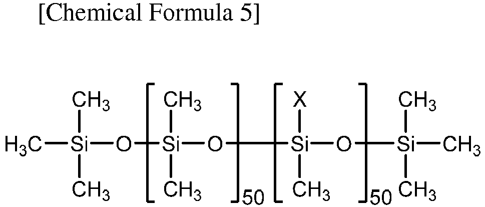

In the formula, X is vinyl.

### Component (e):

benzoyl peroxide (E-1)

Next, a curable silicone composition to be impregnated into pores of a graphite sheet and then cured therein, the graphite sheet being used to construct the inventive heat-dissipating sheet, is formulated from the following components.

### <Curable silicone composition to be impregnated and cured into pores of graphite sheet>

### Component (f):

organopolysiloxane of the following formula

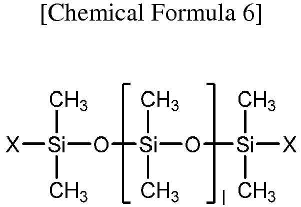

In the formula, X is vinyl, and 1 is a number providing the following viscosity. (F-1) kinematic viscosity 10,000 mm²/s

### Component (g):

organohydrogenpolysiloxane (G-1) of the following formula

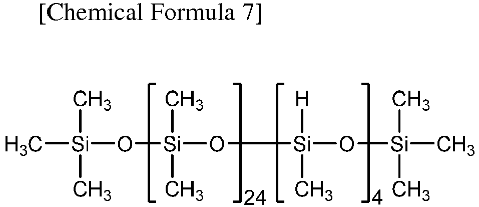

### Component (h):

5 wt% chloroplatinic acid toluene solution (H-1)

### Component (i):

alkoxy-containing organosilicon compound of the following formula; decyltrimethoxysilane (I-1)

C₁₀H₂₁Si(OCH₃)₃

A heat-softening silicone resin to be impregnated into pores of a graphite sheet to construct the inventive heat-dissipating sheet is as follows.

### <Heat-softening silicone resin to be impregnated into pores of graphite sheet>

### Component (k):

siloxane resin (K-1) of the following compositional formula

D¹₂₅T₅₅D²₂₀

In the formula, D¹ is a dimethylsiloxane unit (i.e., (CH₃)₂SiO_{2/2}), T is a phenylsilsesquioxane unit (i.e., (C₆H₅)SiO_{3/2}), and D² is a methylvinylsiloxane unit (i.e., (CH₃)(CH₂=CH)SiO_{2/2}). (Number average molecular weight ∼2,000, softening point 48°C)

A graphite sheet to construct the inventive heat-dissipating sheet and to be impregnated in pores with the above composition or resin is as follows.

### Graphite sheet MacFoil

(Japan Matex Co., Ltd., porosity ∼45 vol%, thickness 130 µm) (L-1)

### <Preparation of graphite sheet layer>

### (On use of curable silicone composition)

A graphite sheet was fed or placed on a polymer film pretreated with a parting agent, the curable silicone composition was coated thereon, another polymer film pretreated with a parting agent was placed on top of the graphite sheet for sandwiching the graphite sheet between two parting agent-treated polymer films. Using a heat press machine, the sandwich was heat treated at 120°C for 10 minutes under a pressure of 3 MPa, whereby the curable silicone composition was impregnated and cured into pores. There was obtained the graphite sheet having pores filled with the cured product (silicone rubber) of the curable silicone composition. The graphite sheet had a thickness of 130 µm at the end of filling.

### (On use of heat-softening silicone resin)

A graphite sheet was fed on a polymer film pretreated with a parting agent, the heat-softening silicone resin liquid diluted with toluene for efficient working was coated on the graphite sheet by means of a knife coater, the coated sheet was passed through a heating furnace at a coating speed of 2 m/min and a temperature of 100°C for volatilizing off the solvent, another polymer film pretreated with a parting agent was placed on top of the graphite sheet for sandwiching the graphite sheet between two parting agent-treated polymer films. Using a heat press machine, the sandwich was heat treated at 120°C for 10 minutes under a pressure of 3 MPa for thermocompression bonding. There was obtained the graphite sheet having pores impregnated and filled with the heat-softening silicone resin. The graphite sheet had a thickness of 130 µm at the end of filling.

### <Preparation of heat-dissipating sheet>

The curable silicone rubber composition in uncured state was coated onto the graphite sheet layer (130 µm thick), after which a polymer film pretreated with a parting agent was placed on top of the coating. Using a heat press machine, the assembly was heat treated at 120°C for 10 minutes under a pressure of 3 MPa for press molding the curable silicone rubber composition on the graphite sheet layer to a thickness of 100 µm. There was obtained a heat-dissipating sheet having a heat-emissive silicone rubber sheet layer of 100 µm thick on the graphite sheet layer.

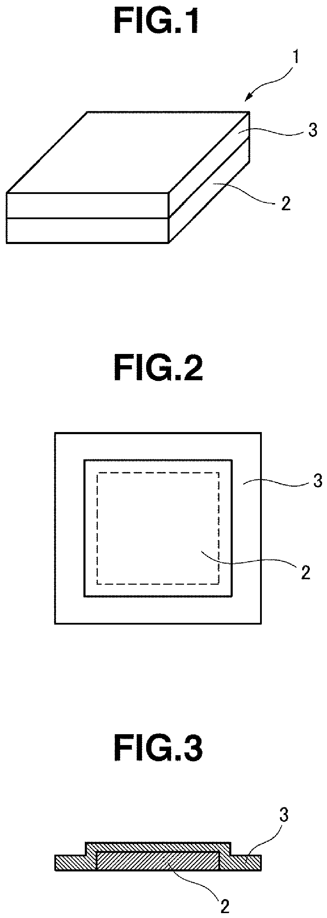

FIG. 1 shows the construction of the heat-dissipating sheet obtained in Examples 1 to 6. FIG. 2 is a plan view of the heat-dissipating sheet obtained in Example 7, and FIG. 3 is a transverse cross-sectional view thereof. Illustrated in FIGS. 1 to 3 are a heat-dissipating sheet 1, a graphite sheet layer 2, and a heat-emissive silicone rubber sheet layer 3.

### [Evaluation methods]

The heat-dissipating sheets thus obtained were tested and measured for the following properties, with the results of evaluation shown in Tables 1 and 2.

### [Heat dissipation]

A power of 8 W was supplied to an aluminum heat generator (heat conducting surface of 15 mm squares by 100 mm height) equipped with a thermocouple. When the aluminum heat generator was heated and reached a constant temperature of 80-81°C, the heat-dissipating sheet was attached to the aluminum heat generator such that their centers were aligned. After 1 minute, the temperature of the aluminum heat generator was measured. The measurement environment was at a temperature of 25±2°C and a humidity of 50±5%.

### [Heat emission]

A picture of the heat-dissipating sheet was taken from top by an IR camera for imaging infrared radiation emitted therefrom after 1 minute from the attachment of the heat-dissipating sheet.
Rating A: IR emission from overall sheet surface
Rating B: IR emission from only the confine and periphery of heat source
Rating C: little IR emission

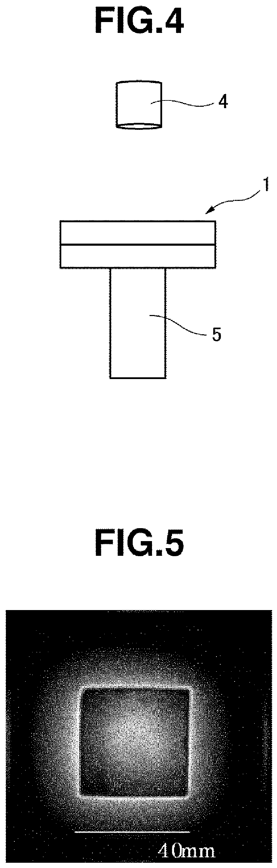

FIG. 4 schematically illustrates an instrument for measuring heat dissipation and heat emission. Illustrated in FIG. 4 are a heat-dissipating sheet 1, an aluminum heat generator 5 equipped with a thermocouple, and an IR camera 4.

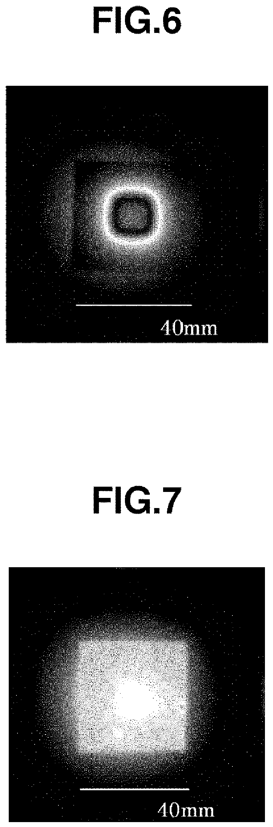

FIG. 5 shows an IR image of Example 1; FIG. 6 shows an IR image of Comparative Example 1; and FIG. 7 shows an IR image of Comparative Example 2.

**[Table 1]**

| | | Example | | | | | |
|---|---|---|---|---|---|---|---|
| | | 1 | 2 | 3 | 4 | 5 | 6 |
| Construction of curable silicone rubber composition | Component (a) | (A-1) 90 pbw | (A-1) 90 pbw | (A-1) 90 pbw | (A-2) 98 pbw | - | (A-1) 90 pbw |
| | Component (b) | (B-1) 10 pbw | (B-1) 10 pbw | (B-1) 10 pbw | (B-1) 2 pbw | - | (B-1) 10 pbw |
| | SiH/SiVi* | 1.05 | 1.05 | 1.05 | 1.05 | - | 1.05 |
| | Component (c) | (C-1) 0.04 pbw | (C-1) 0.04 pbw | (C-1) 0.04 pbw | (B-1) 0.02 pbw | - | (C-1) 0.04 pbw |
| | Component (d) | - | - | - | - | (D-1) 98 pbw | - |
| | Component (e) | - | - | - | - | (E-1) 2 pbw | - |
| | Component (j) | (Al₂O₃-1) 10 pbw | (ZnO-2) 10 pbw | (SiO₂-3) 10 pbw | (Al₂O₃-1) 10 pbw | (Al₂O₃-1) 10 pbw | (Al₂O₃-1) 10 pbw |
| Size of heat-emissive silicone rubber sheet layer | | 40 mm × 40 mm | 40 mm × 40 mm | 40 mm × 40 mm | 40 mm × 40 mm | 40 mm × 40 mm | 40 mm × 40 mm |
| Construction of graphite sheet composition | Component (f) | (F-1) 97 pbw | (F-1) 97 pbw | (F-1) 97 pbw | (F-1) 97 pbw | (F-1) 97 pbw | - |
| | Component (g) | (G-1) 3 pbw | (G-1) 3 pbw | (G-1) 3 pbw | (G-1) 3 pbw | (G-1) 3 pbw | - |
| | SiH/SiVi* | 1.05 | 1.05 | 1.05 | 1.05 | 1.05 | - |
| | Component (h) | (H-1) 0.03 pbw | (H-1) 0.03 pbw | (H-1) 0.03 pbw | (H-1) 0.03 pbw | (H-1) 0.03 pbw | - |
| | Component (i) | (I-1) 20 pbw | (I-1) 20 pbw | (I-1) 20 pbw | (I-1) 20 pbw | (I-1) 20 pbw | - |
| | Component (k) | | | - | - | - | (K-1) |
| | Starting graphite sheet | (L-1) | (L-1) | (L-1) | (L-1) | (L-1) | (L-1) |
| Size of graphite sheet layer | | 40 mm × 40 mm | 40 mm × 40 mm | 40 mm × 40 mm | 40 mm × 40 mm | 40 mm × 40 mm | 40 mm × 40 mm |
| Heat dissipation (°C) | | 65 | 67 | 67 | 65 | 65 | 63 |
| Heat emission | | A | A | A | A | A | A |

| | | | | | | | |
|---|---|---|---|---|---|---|---|
| * Molar ratio of SiH groups in organohydrogenpolysiloxane to alkenyl groups in alkenyl-containing organopolysiloxane ** Each of the curable silicone composition comprising components (f) to (i) and the heat-softening silicone resin of component (K) was coated and impregnated in an amount of 100 vol% relative to the pore volume of the graphite sheet. | | | | | | | |

**[Table 2]**

| | | Example | Comparative Example | | |
|---|---|---|---|---|---|
| | | 7 | 1 | 2 | 3 |
| Construction of curable silicone rubber composition | Component (a) | (A-1) 90 pbw | (A-1) 90 pbw | - | - |
| | Component (b) | (B-1) 10 pbw | (B-1) 10 pbw | - | - |
| | SiH/SiVi* | 1.05 | 1.05 | - | - |
| | Component (c) | (C-1) 0.04 pbw | (C-1) 0.04 pbw | - | - |
| | Component (d) | - | - | - | - |
| | Component (e) | - | - | - | - |
| | Component (j) | (Al₂O₃-1) 10 pbw | (Al₂O₃-1) 10 pbw | - | - |
| Size of heat-emissive silicone rubber sheet layer | | 45 mm × 45 mm | 40 mm × 40 mm | - | - |
| Construction of graphite sheet composition | Component (f) | (F-1) 97 pbw | - | (F-1) 97 pbw | - |
| | Component (g) | (G-1) 3 pbw | - | (G-1) 3 pbw | - |
| | SiH/SiVi* | 1.05 | - | 1.05 | - |
| | Component (h) | (H-1) 0.03 pbw | - | (H-1) 0.03 pbw | - |
| | Component (i) | (I-1) 20 pbw | - | (I-1) 20 pbw | - |
| | Component (k) | | - | - | - |
| | Starting graphite sheet | (L-1) | - | (L-1) | - |
| Size of graphite sheet layer | | 40 mm × 40 mm | - | 40 mm × 40 mm | - |
| Aluminum foil (comparison) | Thickness | - | - | - | 50 µm |
| | Size | - | - | - | 40 mm × 40 mm |
| Heat dissipation (°C) | | 63 | 70 | 72 | 73 |
| Heat emission | | A | B | C | C |

| | | | | | |
|---|---|---|---|---|---|
| * Molar ratio of SiH groups in organohydrogenpolysiloxane to alkenyl groups in alkenyl-containing organopolysiloxane ** The curable silicone composition comprising components (f) to (i) was coated and impregnated in an amount of 100 vol% relative to the pore volume of the graphite sheet. | | | | | |

As is evident from Table 1, each Example shows high heat dissipation and improved heat emission, as demonstrated by the IR image of Example 1 shown in FIG. 5.

As is evident from Table 2, the heat-dissipating sheet of Example 7 (FIGS. 2 and 3) in which an area in in-plane direction of the heat-emissive silicone rubber sheet layer is greater than an area in in-plane direction of the graphite sheet layer so that machining chips and debris of graphite may not come in contact with the electronic part shows high heat dissipation and improved heat emission. In contrast, Comparative Example 1 devoid of a graphite sheet layer shows low heat dissipation and restricted heat emission, as demonstrated by the IR image of Comparative Example 1 shown in FIG. 6. Comparative Example 2 devoid of a heat-emissive silicone rubber sheet layer shows low heat dissipation and low heat emission, as demonstrated by the IR image of Comparative Example 2 shown in FIG. 7.

### REFERENCE SIGNS LIST

- 1: heat-dissipating sheet
- 2: graphite sheet layer
- 3: heat-emissive silicone rubber sheet layer
- 4: IR camera
- 5: aluminum heat generator equipped with thermocouple

## Claims

1. A heat-dissipating sheet comprising a graphite sheet layer and a heat-emissive silicone rubber sheet layer, which is obtained by stacking a heat-emissive silicone rubber sheet and a graphite sheet, which has been formed by impregnating it in pores with a silicone resin or impregnating it in pores with a curable silicone composition and curing the silicone composition, without intervening any adhesive layer.

2. The heat-dissipating sheet of claim 1 wherein when an outer surface of the graphite sheet layer is contacted with a heat-generating body, heat is conducted from the heat-generating body to the graphite sheet layer, the heat is absorbed and diffused by the heat-emissive silicone rubber sheet layer, and the heat-emissive silicone rubber sheet layer emits infrared radiation from its outer surface.

3. The heat-dissipating sheet of claim 1 or 2 wherein the heat-emissive silicone rubber sheet is a cured product of a curable silicone rubber composition containing oxide ceramic.

4. The heat-dissipating sheet of claim 3 wherein the curable silicone rubber composition containing oxide ceramic is a curable silicone rubber composition comprising
(a) 100 parts by weight of an organopolysiloxane containing at least two silicon-bonded alkenyl groups per molecule, represented by the average compositional formula (1):
RₐSiO_{(4-a)/2} (1)
wherein R is independently a substituted or unsubstituted monovalent hydrocarbon group of 1 to 12 carbon atoms, and a is a positive number of 1.8 to 2.2,
(b) an organohydrogenpolysiloxane containing at least two silicon-bonded hydrogen atoms per molecule, in such an amount that a molar ratio of silicon-bonded hydrogen atoms in component (b) to alkenyl groups in component (a) may range from 0.5 to 5.0,
(c) an amount of a platinum base compound to give 0.1 to 1,000 ppm of platinum group metal element based on the weight of component (a), and
(j) 2 to 200 parts by weight of oxide ceramic.

5. The heat-dissipating sheet of claim 3 wherein the curable silicone rubber composition containing oxide ceramic is a curable silicone rubber composition comprising (d) 100 parts by weight of an organopolysiloxane containing at least two alkenyl groups per molecule,
(e) 0.1 to 2 parts by weight of an organic peroxide compound, and
(j) 2 to 200 parts by weight of oxide ceramic.

6. The heat-dissipating sheet of any one of claims 1 to 5 wherein the curable silicone composition with which the graphite sheet is impregnated in pores is a curable silicone composition comprising
(f) 100 parts by weight of an organopolysiloxane containing at least two silicon-bonded alkenyl groups per molecule, represented by the average compositional formula (2):
R¹_{b}SiO_{(4-b)/2} (2)
wherein R¹ is independently a substituted or unsubstituted monovalent hydrocarbon group of 1 to 12 carbon atoms, and b is a positive number of 1.8 to 2.2,
(g) an organohydrogenpolysiloxane containing at least two silicon-bonded hydrogen atoms per molecule, in such an amount that a molar ratio of silicon-bonded hydrogen atoms in component (g) to alkenyl groups in component (f) may range from 0.5 to 5.0,
(h) an amount of a platinum base compound to give 0.1 to 1,000 ppm of platinum group metal element based on the weight of component (f), and
(i) 0.01 to 50 parts by weight of an alkoxy-containing organosilicon compound.

7. The heat-dissipating sheet of any one of claims 1 to 5 wherein the silicone resin with which the graphite sheet is impregnated in pores is a heat-softening silicone resin which is substantially solid at room temperature.

8. The heat-dissipating sheet of claim 7 wherein the heat-softening silicone resin contains difunctional siloxane structural units (D units) and trifunctional silsesquioxane structural units (T units).

9. The heat-dissipating sheet of claim 7 or 8 wherein the heat-softening silicone resin has a softening point of 40 to 120°C.

10. The heat-dissipating sheet of any one of claims 1 to 9 wherein an area in in-plane direction of the heat-emissive silicone rubber sheet layer is greater than an area in in-plane direction of the graphite sheet layer opposed thereto.
